Europäisches Patentamt

European Patent Office

Office européen des brevets

(11) Publication number: **0 396 276**
**A2**

(12) # EUROPEAN PATENT APPLICATION

(21) Application number: **90304147.3**

(51) Int. Cl.⁵: **H01L 21/60**

(22) Date of filing: **18.04.90**

(30) Priority: **18.04.89 JP 99517/89**

(43) Date of publication of application:
**07.11.90 Bulletin 90/45**

(84) Designated Contracting States:
**DE FR GB**

(71) Applicant: **NEC CORPORATION**
**7-1, Shiba 5-chome Minato-ku**
**Tokyo 108-01(JP)**

(72) Inventor: **Kobayashi, Takaaki**
**c/o NEC Corporation, 7-1, Shiba 5-chome**
**Minato-ku, Tokyo(JP)**

(74) Representative: **Pritchard, Colin Hubert et al**
**Mathys & Squire 10 Fleet Street**
**London EC4Y 1AY(GB)**

(54) **Method of manufacturing semiconductor device.**

(57) According to a method of manufacturing a semiconductor device with a semiconductor element, a wiring layer is formed on a semiconductor substrate on which a semiconductor element is formed. A first window is formed to expose a first surface portion of the wiring layer in a protective film which covers the entire surface of the semiconductor substrate. A metal film is formed on the entire surface including the first protective film and within the first window. A second window having an opening smaller than that of the first window is formed in the metal film to expose a second surface portion of the wiring layer within the first surface portion. Electrolytic plating is performed using the metal film as a current path to form a projecting metal electrode on the second surface portion of the wiring layer in the second window. Thereafter, the metal film is removed.

FIG.1D

EP 0 396 276 A2

## Method of Manufacturing Semiconductor Device

### Background of the Invention

The present invention relates to a method of manufacturing a semiconductor device and, more particularly, to a method of manufacturing a semiconductor device having a projecting metal electrode.

A conventional method of manufacturing a semiconductor device having an projecting metal electrode formed by plating is performed as follows. An underlying wiring layer is formed, and a metal film which is to serve as a current path during plating is formed on the entire surface of a semiconductor substrate. An underlying film is formed on a region of the metal film, on which a projecting metal electrode is formed, by a lift-off method using a photoresist film, and plating is performed using a photoresist film exposing only the underlying film as a mask to form a projecting metal electrode on only the underlying film. The photoresist film is removed, and an unnecessary metal film is removed by etching using the projecting metal electrode as a mask. Thereafter, a protective film is formed on the entire surface of the semiconductor substrate, and the protective film is selectively removed by etching using a photoresist film as a mask to expose only the projecting electrode as a bonding region.

The above conventional method of manufacturing a semiconductor device having a projecting metal electrode has the following drawbacks. Since a protective film is formed after formation of a projecting metal electrode and a bonding region on the projecting matal electrode is removed by etching to form a final protective film, an etching residue of the protective film is formed on the surface of the projecting metal electrode porously grown by plating, thereby largely degrading a bonding strength between a carrier tape and the semiconductor device.

### Summary of the Invention

It is a principal object of the present invention to provide a method of manufacturing a semiconductor device capable of improving reliability of a mechanical and. electrical connection in a projecting metal electrode.

It is another object of the present invention to provide a method of manufacturing a semiconductor device capable of preventing an increase in lateral size of the projecting metal electrode, micropatterning the projecting metal electrode and highly integrating a semiconductor device.

In order to achieve the above objects, according to the present invention, there is provided a method of manufacturing a semiconductor device with a semiconductor element comprising the steps of forming a wiring layer on a semiconductor substrate; forming a protective film entirely; forming a first window in the protective film to expose a first surface portion of the wiring layer; forming a metal film continuously on the protective film and on the first surface portion of the wiring layer within the first window; forming a mask layer on the metal film; forming a second window in the metal film using the mask layer as a mask to expose a second surface portion of the wiring layer positioned within the first surface portion such that the metal film is left contacting to the first surface portion outside and periphery of the second surface portion of the wiring layer; performing electrolytic plating using the mask layer as a mask and using the metal film as a current path to form a projecting metal electrode on the second surface portion of the wiring layer; and removing the mask layer and the metal film.

### Brief Description of the Drawings

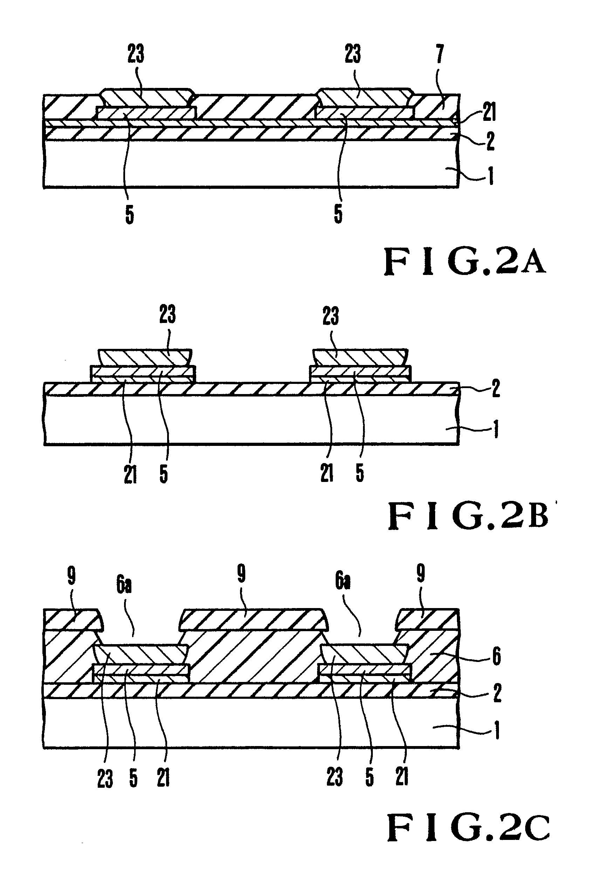

Figs. 1A to 1D and Figs. 2A to 2E are sectional views showing the steps in manufacturing a semiconductor chip for respectively explaining first and second embodiments of the present invention.

### Description of the Preferred Embodiments

Embodiments of the present invention will be described below with reference to the accompanying drawings.

Figs. 1A to 1D show the steps in manufacturing a semiconductor chip for explaining an embodiment of the present invention.

As shown in Fig. 1A, a semiconductor element (a portion 100 thereof is shown) is formed on a silicon substrate 1 by a normal method, and a silicon oxide film 2 as a field insulating layer having a thickness of about 1 $\mu$m is formed on the major surface of the resultant structure. Al (aluminum) wiring layers 3 are formed on the silicon oxide film 2. A silicon nitride film 4 is deposited as a protective film, and openings are respectively formed in portions of the silicon nitride film which is located above a region for forming a projecting metal electrode on the Al wiring layer 3. Ti-Pt films 5 which are to serve as underlying films of a projecting metal electrode are formed on regions including the openings. Each of Ti-Pt films has a two-layered structure constituted of a Ti film attached to the Al wiring layer 3 for increasing bonding strength with the Al wiring 3 and a Pt film attached to the Ti film for preventing a reaction between Au of a projecting gold electrode, that is, a bump electrode formed in the following steps and Al contained in the Al wiring layer 3, and the Ti-Pt films are formed using selective etching or a lift-off method.

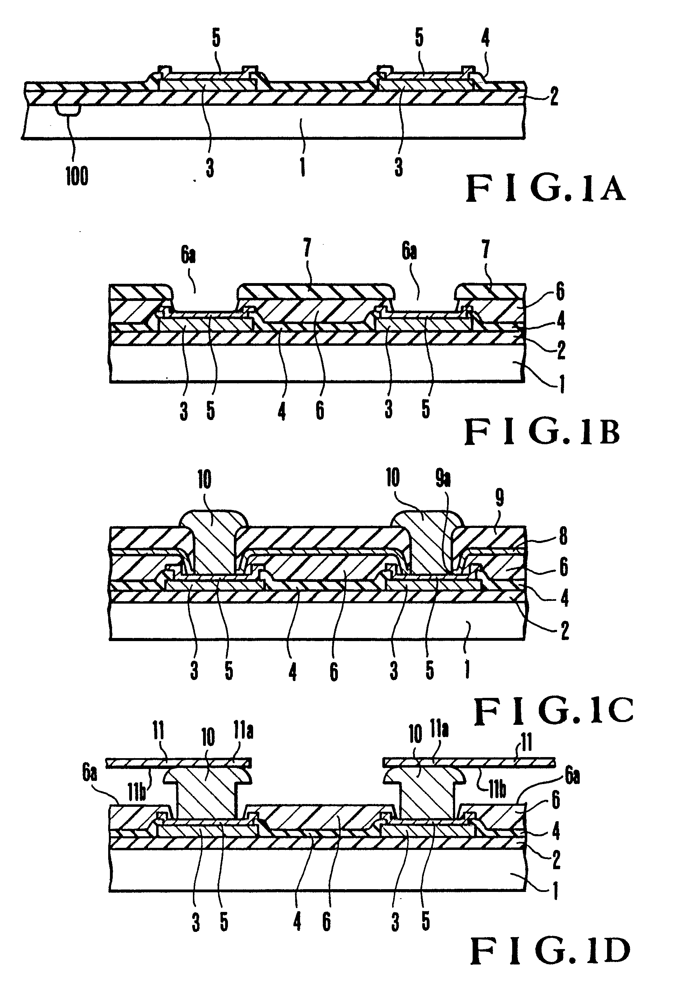

Next, as shown in Fig. 1B, a polyimide resin film 6 having a thickness of about 3 μm is formed on the entire surface of the substrate as a final protective film, for example. A first photoresist film 7 is formed on the resultant structure, and the polyimide resin film 6 is selectively etched using the patterned first photoresist film 7 as a mask. Windows 6a are formed in regions for forming the projecting gold electrodes to expose the Pt film of the Ti-Pt films 5.

Next, as shown in Fig. 1C, after the first photoresist film 7 is removed, a metal film 8 is formed by sputtering on the entire surface of the substrate including the Ti-Pt films 5 in the window 6a and the polyimide resin film 6. In this case, a Ti film having good processability is used in the metal film 8. A second photoresist film 9 is formed on the resultant structure and patterned to form windows 9a smaller than the windows 6a. The metal film 8 is etched using the second photoresist film 9 as a mask to expose the Ti-Pt films 5. Since each of the windows 9a of the second photoresist film 9 is smaller than each window 6a of the first photoresist film, the metal film 8 is connected to the Ti-Pt films 5 after forming the windows 9a. Therefore, potentials of a plurality of Ti-Pt films 5 formed on the substrate are equal to each other.

The silicon substrate 1 is dipped in an Au plating solution. A current flows between an anode of a plating device and a cathode by using the metal film 8 as a cathode current path to perform plating, and desired plating layers, i.e., projecting gold electrodes 10 as bump terminal electrodes each having a thickness of about 20 μm, are formed on the Ti-Pt films 5.

As shown in Fig. 1D, the second photoresist film 9 is removed, and the metal film 8 is etched using the projecting gold electrodes 10 as masks. The projecting gold electrodes 10 are electrically insulated and independent of each other, thereby completing a semiconductor device. After dividing to each semiconductor chip from the semiconductor wafer, the tip portions 11a of leads 11 of a carrier tape or of a lead frame are bonded by a well known gang bonding method to the upper surfaces of the projecting metal electrodes 10 as bump terminal electrode, simultaneously so that each of leads 11 is substantially horizontally formed at its other portion 11b facing the upper surface 6a of the polyimide film 6 as the protective or passivation film without interposing any other material therebetween. Thereafter, the structure is resin sealed in a mold package or molded in a ceramic package.

In the present invention, the polyimide resin film 6 serving as a final protective film is formed in advance, and then the projecting gold electrodes 10 are formed by a plating method. Therefore, even if the surfaces of the projecting gold electrodes 10 are porously formed, there is no etching residue on these surfaces. The projecting gold electrodes 10 can be mechanically and electrically connected to the conductive surface of a tape carrier at high reliability during bonding. Since the windows 6a are formed in the polyimide resin film 6 in advance to limit a region for forming the projecting gold electrodes, an increase in lateral size of the gold plating layer caused by isotropic growth of gold plating can be restrained. In addition, planar areas of the projecting gold electrodes 10 can be reduced to micropattern a semiconductor device.

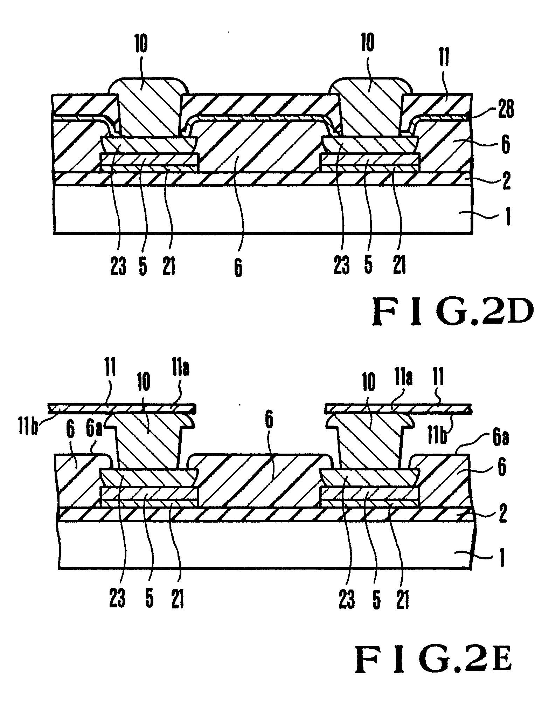

Figs. 2A to 2E show the steps in manufacturing a semiconductor chip for explaining the second embodiment of the present invention. In Fig. 2, the same components as those in Fig. 1 are indicated by the same reference numerals.

As shown in Fig. 2A, a semiconductor element (not shown) is formed on a silicon substrate 1 by a normal method, and the silicon oxide film 2 is formed on the surface of the substrate. A first metal film 21 having a predetermined pattern is formed on the silicon oxide film 2 by sputtering. At this time, a Ti film having good processability is used as the first metal film 21. Ti-Pt films 5 which are to serve as underlying films for plating are formed on the first metal film 21. Each of the Ti-Pt films 5 has a two-layered structure constituted of a Ti film for increasing bonding strength with the metal film 21 and a Pt film for preventing diffusion of Au as in the first embodiment, and the Ti-Pt films 5 are formed by selective etching or a lift-off method. The silicon substrate 1 is dipped in a gold plating solution using as a mask the photoresist film 7 exposing the regions for the Ti-Pt films 5. A current flows between an anode of a electrolytic plating apparatus and a cathode by using the first metal film 21 as a cathode current path, and desired gold plating layers, i.e., gold wiring layers 23 each having a thickness of about 5 μm are formed on only the Ti-Pt films 5.

As shown in Fig. 2B, the first photoresist film 7 is removed. An unnecessary part of the first metal film 21 is removed by etching using the gold wiring layer 23 and the Ti-Pt film 5 as masks.

As shown in Fig. 2C, e.g., a polyimide resin film 6 is formed on the entire surface of the resultant structure as a final protective film. The polyimide region 6 is selectively etched using a patterned second photoresist film 9 as a mask to form windows 6a in the photoresist film 9, thereby exposing the gold wiring layers 23.

· As shown in Fig. 2D, after the second photoresist film is removed, a second metal film 28 is formed on the entire surface of the resultant structure. The metal film 28 is selectively removed by etching using a third photoresist film 11 as a mask to form windows each having a smaller size than that of the window 6a in the windows 6a, thereby exposing the gold wiring layers 23. The resultant structure is plated using the second metal film 28 as a current path, and desired gold plating layers, i.e., projecting gold electrodes 10 each having a thickness of 20 $\mu$m, are formed on the gold wiring layer 23 exposed from the windows.

As shown in Fig. 2E, the third photoresist film 11 and the second metal film 28 are removed by etching, and a semiconductor device having the projecting old electrodes 10 is completed.

In this embodiment, the polyimide resin film 6 serving as a final protective film is formed in advance, and the projecting gold electrodes 10 are formed. Therefore, there is no etching residue of the polyimide resin film 6. In this case, other metals can be used for the metal film 28 serving as a current path for plating, and other metals except for Au can be used for projecting electrodes.

As described above, the present invnetion includes the following steps. After formation of an underlying wiring layer, a metal film serving as a current path during plating is formed. A window is formed in a region of the metal film for forming a projecting metal electrode, and the projecting metal electrode is formed in the window by plating. Thereafter, the metal conductive film is removed by etching. Thus, since a protective film need not be removed after formation of the projecting metal electrode, an etching residue is not left on the surface of the projecting metal electrode. Therefore, reliability of mechanical and electrical connections on the projecting metal electrode can be improved. In addition, since the projecting metal electrode is formed after formation of the window in the protective film, a lateral size of the projecting metal electrode can be reduced, thereby micropatterning the projecting metal electrode. Therefore, a highly integrated semiconductor device can be realized.

## Claims

1. A method of manufacturing a semiconductor device with a semiconductor element comprising the steps of:

forming a wiring layer on a semiconductor substrate;
forming a protective film on the wiring layer;
forming a first window in said protective film to expose a first surface portion of said wiring layer;
forming a metal film continuously on said protective film and on said first surface portion of said wiring layer within said first window;
forming a mask layer on said metal film;
forming a second window in said metal film using said mask layer as a mask to expose a second surface portion of said wiring layer positioned within said first surface portion such that said metal film is left contacting to said first surface portion outside and periphery of said second surface portion of said wiring layer;
performing electrolytic plating using said mask layer as a mask and using said metal film as a current path to form a projecting metal electrode on said second surface portion of said wiring layer; and removing said mask layer and said metal film.

2. A method according to claim 1, wherein said protective film is made of a polyimide resin film.

3. A method according to claim 1, wherein said mask layer is made of a photoresist film.

4. A method according to claim 1, wherein said wiring layer includes an aluminum layer and a two-layered structure selectively formed on said aluminum layer and constituting said first and second surface portions.

5. A method according to claim 4, wherein said two-layered structure is composed of a titanium film attached to said aluminum layer and a platinum film attached to said titanium film, and said metal film is made of a titanium film.

6. A method according to claim 1, wherein said electrolytic plating is a gold plating to form said projecting metal electrode of gold.

7. A method according to claim 1, wherein said forming said wiring layer includes the steps of:
forming a first metal film entirely on a major surface of said substrate via an insulating layer;
forming selectively a second metal film having a wiring pattern on said first metal film;
foring a third metal film on said second metal film by electrolytic plating using said first metal film as a current path; and
patterning said first metal film by etching using said second and third metals films as a mask.

8. A method according to claim 7, wherein said second metal film is composed of a titanium film attached to said first metal film and a platinum film attached to said titanium film, and said third metal film is made of gold.

9. A method according to claim 1, further comprising a step of connecting a lead to the top surface of said projecting metal at its tip portion and extending substantially, horizontally at its other portion so that said other portion of said lead faces
directly the upper surface of said protective film.

FIG.1A

FIG.1B

FIG.1C

FIG.1D

F I G.2A

F I G.2B

F I G.2C

# F I G.2D

# F I G.2E